(19) Europäisches Patentamt
European Patent Office
Office européen des brevets

(11) EP 2 076 098 B1

(12) **EUROPEAN PATENT SPECIFICATION**

(45) Date of publication and mention of the grant of the patent:
**11.05.2011 Bulletin 2011/19**

(51) Int Cl.:
***H05K 1/00*** *(2006.01)* ***H05K 1/02*** *(2006.01)*

(21) Application number: **08009523.5**

(22) Date of filing: **23.05.2008**

(54) **Flexible film and display device comprising the same**

Flexible Folie und Anzeigevorrichtung damit

Film flexible et dispositif d'affichage comportant ce film

(84) Designated Contracting States:
**DE FR GB NL**

(30) Priority: **27.12.2007 KR 20070138825**

(43) Date of publication of application:
**01.07.2009 Bulletin 2009/27**

(73) Proprietor: **LG Electronics Inc.**
**Seoul 150-721 (KR)**

(72) Inventors:
- **Lee, Sang Gon**
**Chungju-si,**
**Choongchungbuk-do 361-480 (KR)**
- **Kim, Dae Sung**
**Chungju-si,**
**Choongchungbuk-do 361-480 (KR)**
- **Chang, Woo Hyuck**
**Chungju-si,**
**Choongchungbuk-do 361-480 (KR)**

(74) Representative: **Katérle, Axel**
**Wuesthoff & Wuesthoff**
**Patent- und Rechtsanwälte**
**Schweigerstraße 2**
**81541 München (DE)**

(56) References cited:
**EP-A- 0 284 939**
**EP-A- 1 529 812**
**US-A1- 2003 024 666**
**US-A1- 2004 140 551**
**US-A1- 2005 168 304**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 076 098 B1

## Description

### BACKGROUND OF THE INVENTION

1. Field of the Invention

The present invention relates to a flexible film, and more particularly, to a flexible film, which includes a dielectric film having a water absorbency of 0.01-3.5% and a metal layer disposed on the dielectric film, and can thus improve the peel strength between the dielectric film and the metal layer and can be applied to a high-scan rate display device.

2. Description of the Related Art

With recent improvements in flat panel display technology, various types of flat panel display devices such as a liquid crystal display (LCD), a plasma display panel (PDP), and an organic light-emitting diode (OLED) have been developed. Flat panel display devices include a driving unit and a panel and display images by transmitting image signals from the driving unit to a plurality of electrodes included in the panel.

Printed circuit boards (PCBs) may be used as the driving units of flat panel display devices. That is, PCBs may apply image signals to a plurality of electrodes included in a panel and thus enable the panel to display images. The driving units of flat panel display devices may transmit image signals to a plurality of electrodes of a panel using a chip-on-glass (COG) method.

The COG method is characterized by mounting integrated circuits (ICs) directly on a glass substrate of a panel, and can thus contribute to the reduction of the manufacturing cost of flat panel display devices. However, the COG method requires glass substrates large enough to mount ICs thereon.

EP 1529 812 discloses a polymeric composite comprising a polyimide component and an fluoropolymer component derived from a micro powder to form a thin film used in highspeed digital circuitry for low loss of a digital signal, and may also be used as a base film substrate for flexible circuitry laminates.

US 2004/0140551 discloses a lightweight semiconductor device having a multi-layer interconnect line structure disposed under circuit devices bonded to the semiconductor device. An interlayer insulating film disposed between layers of the muilti-layer structure has via holes to interconnect metal layers of the multi-layer structure, and may have a water absorption rate of less than 0.1% to prevent penetration of water into the semiconductor chips.

US 2003/0024666 discloses an insulative fluororesin fiber paper having low water absorption that is laminated to a copper foil by means of vacuum hot pressing.

### SUMMARY OF THE INVENTION

The present invention provides a flexible film, according to claim 1. The flexible film includes a dielectric film having a water absorbency of 0.01-3.5% and can thus have excellent thermal resistance, tensile strength and dimension stability.

The flexible film further includes a metal layer disposed on the dielectric film, and may circuit patterns printed thereon; and an integrated circuit (IC) chip disposed on the metal layer, wherein chip is connected to the circuit patterns.

According to another aspect of the present invention, there is provided a display device according to claim 9.

### BRIEF DESCRIPTION OF THE DRAWINGS

The above and other features and advantages of the present invention will become more apparent by describing in detail preferred embodiments thereof with reference to the attached drawings in which:

FIGS. 1A and 1F illustrate cross-sectional views of flexible films according to embodiments of the present invention;
FIGS. 2A and 2B illustrate diagrams of a tape carrier package (TCP) comprising a flexible film according to an embodiment of the present invention;
FIGS. 3A and 3B illustrate diagrams of a chip-on-film (COF) comprising a flexible film according to an embodiment of the present invention;

### DETAILED DESCRIPTION OF THE INVENTION

The present invention will hereinafter be described in detail with reference to the accompanying drawings in which exemplary embodiments of the invention are shown.

FIGS. 1A through 1F illustrate cross-sectional views of flexible films 100a through 100f, respectively, according

to embodiments of the present invention. Referring to FIGS. 1A through 1F, the flexible films 100a through 100f transmit an image signal provided by a driving unit of a tape automated bonding (TAB)-type display device to an electrode on a panel of the TAB-type display device.

Referring to FIG. 1A, the flexible film 100a, which has a double-layer structure and is single-sided, includes a dielectric film 110a, a first metal layer 120a, which is disposed on the dielectric film 110a, and a second metal layer 130a, which is disposed on the first metal layer 120a. Referring to FIG. 1B, the flexible film 100b, which has a double-layer structure and is double-sided, includes a dielectric film 110b, two first metal layers 120b, which are disposed on the top surface and the bottom surface, respectively, of the dielectric film 110b, and two second metal layers 130b, which are disposed on the respective first metal layers 120b.

The dielectric film 110a or 110b, which is a base film of the flexible film 100a or 100b, may include a dielectric polymer material such as polyimide, polyester or a liquid crystal polymer. The dielectric film 110a or 110b considerably affects the physical properties of the flexible film 100a or 100b such as tensile strength, volume resistance and thermal shrinkage. Therefore, in order to improve the physical properties of the flexible film 100a or 100b, the dielectric film 110a or 110b may be formed of a polymer material having excellent stability.

The amount of water contained in the dielectric film 110a or 110b may affect the permittivity of the flexible film 100a or 100b. Therefore, if the dielectric film 110a or 110b has high water absorbency, the permittivity of the dielectric film 110a or 110b may increase according to humidity.

An increase in the permittivity of the dielectric film 110a or 110b may adversely affect the transmission of image signals having a high scan rate. In order to realize high-definition (HD) broadcasting, it is necessary to transmit image signals having a high scan rate from a driving unit of a display device to a panel of the display device. In order to transmit image signals having a high scan rate, the material of the flexible film 100a or 100b may need to be able to be quickly polarized. Therefore, the water absorbency of the flexible film 100a or 100b must be limited to below a certain level.

The water absorbency of the dielectric film 110a or 110b may be measured according to IPC TM-650 2.6.2 Standard. More specifically, according to IPC TM-650 2.6.2 Standard, the dielectric film 110a or 110b may be exposed to moisture at a temperature of 23±1°C for twenty four hours, thereby measuring the water absorbency of the dielectric film 110a or 110b. The water absorbency of the dielectric film 110a or 110b may be represented by Equation (1):

$$\frac{W_2 - W_1}{W_1} \times 100 \qquad \ldots(1)$$

where $W_1$ indicates the weight of the dielectric film 110a or 110b, which is yet to absorb moisture, and $W_2$ indicates the weight of the dielectric film 110a or 110b, which has absorbed moisture. The dielectric film 110a or 110b may be formed of a polymer material having a water absorbency of 0.01-3.5% in consideration of the permittivity of the flexible film 100a or 100b.

The dielectric film 110a or 110b may be formed of a polymer material such as polyimide or a liquid crystal polymer so as to have a water absorbency of 0.01-3.5%. The dielectric film 110a or 110b may be formed of polyimide, which has a water absorbency of about 3% under IPC TM-650 2.6.2 conditions, or a liquid crystal polymer, which has a water absorbency of about 0.04% under IPC TM-650 2.6.2 conditions.

A liquid crystal polymer, which can be used to form the dielectric film 110a or 110b, may be a combination of p-hydroxybenzoic acid (HBA) and 6-hydroxy-2-naphthoic acid (HNA). HBA is an isomer of hydroxybenzoic acid having one benzene ring and is a colorless solid crystal. HNA has two benzene rings.

HBA may be represented by Formula 1:

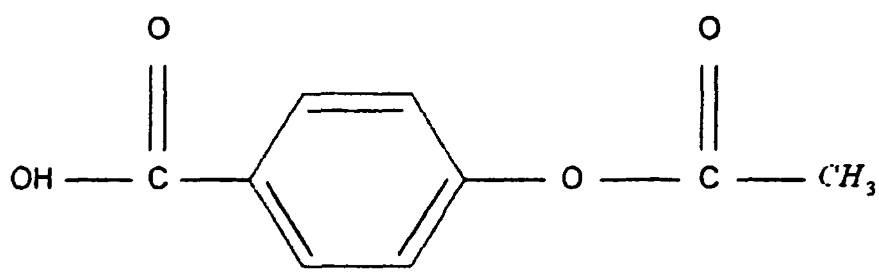

...(1).

HNA may be represented by Formula (2):

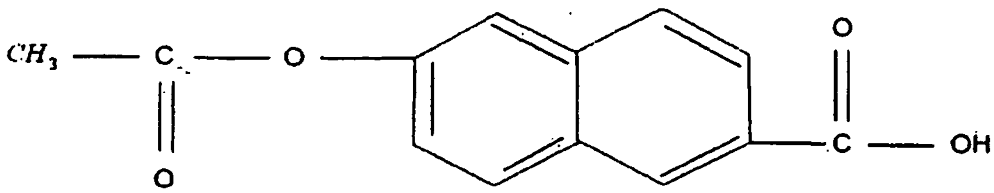

...(2).

A chemical reaction of HBA and HNA to form a liquid crystal polymer may be represented by Formula (3):

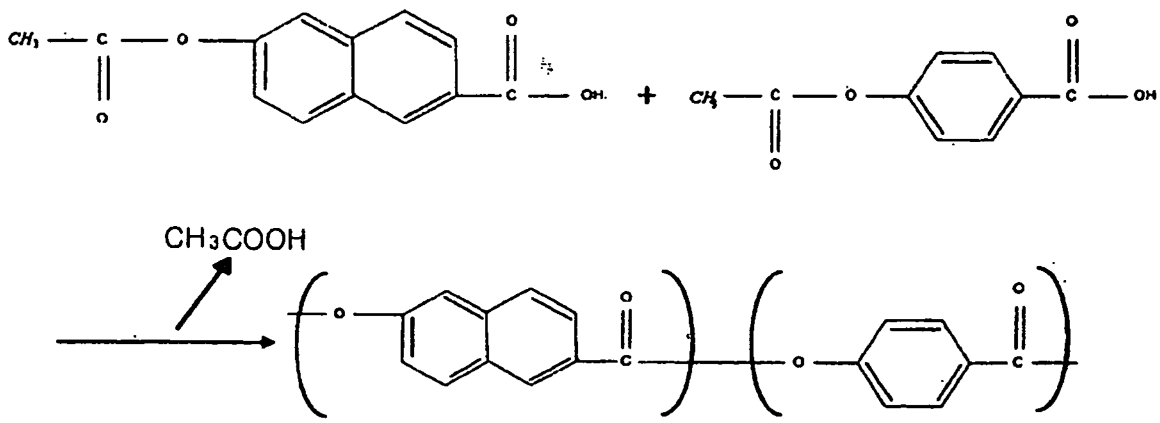


...(3).

During the formation of a liquid crystal polymer, a carboxy radical (-OH) of HNA and an acetic group ($CH_3CO$) of HBA are bonded, thereby forming acetic acid ($CH_3COOH$). This deacetylation may be caused by heating a mixture of HNA and HBA at a temperature of about 200 ˚C.

A liquid crystal polymer, which is obtained by successive bonding of HBA and HNA, has excellent thermal stability and excellent hygroscopic properties. More specifically, the dielectric film 110a or 110b may be formed of a liquid crystal polymer, which has a water absorbency of about 0.04% under IPC TM-650 2.6.2 conditions. When the dielectric film 110a or 110b is formed of a liquid crystal polymer, the flexible film 100a or 100b can efficiently transmit signals having a high scan rate because the dielectric film 110a or 110b has low water absorbency.

The first metal layer 120a and the second metal layer 130a or the first metal layers 120b and the second metal layers 130b are thin conductive metal films disposed on the dielectric film 110a or 110b. The first metal layer 120a and the second metal layer 130a or the first metal layers 120b and the second metal layers 130b may be formed through sputtering, electroless plating or electroplating. For example, the first metal layer 120a or the first metal layers 120b may be formed through sputtering or electroless plating, and the second metal layer 130a or the second metal layers 130b may be formed through electroplating.

Table 1 below shows the relationship between the ratio of the thickness of a metal layer to the thickness of a dielectric layer and the properties of a flexible film when the dielectric layer has a thickness of 38 $\mu$m.

Table 1

| Thickness of Metal Layer:Thickness of Dielectric Film | Flexibility | Peel Strength |
|---|---|---|
| 1:1.4 | × | ◎ |
| 1:1.5 | ○ | ○ |
| 1:2 | ○ | ○ |

(continued)

| Thickness of Metal Layer:Thickness of Dielectric Film | Flexibility | Peel Strength |
|---|---|---|
| 1:4 | ○ | ○ |
| 1:6 | ○ | ○ |
| 1:8 | ○ | ○ |
| 1:10 | ○ | ○ |
| 1:11 | ○ | × |
| 1:12 | ◎ | × |
| 1:13 | ◎ | × |

Referring to Table 1, electroless plating or electroplating may be performed so that the ratio of the sum of the thicknesses of the first metal layer 120a and the second metal layer 130a to the thickness of the dielectric film 110a can be within the range of 1:1.5 to 1:10. If the sum of the thicknesses of the first metal layer 120a and the second metal layer 130a is less than one tenth of the thickness of the dielectric film 110a, the peel strength of the first metal layer 120a and the second metal layer 130a may decrease, and thus, the first metal layer 120a and the second metal layer 130a may be easily detached from the dielectric film 110a or the stability of the dimension of circuit patterns on the first metal layer 120a and the second metal layer 130a may deteriorate.

On the other hand, if the sum of the thicknesses of the first metal layer 120a and the second metal layer 130a is greater than two thirds of the thickness of the dielectric film 110a, the flexibility of the flexible film 100a may deteriorate, or the time taken to perform plating may increase, thereby increasing the likelihood of the first and second metal layers 120a and 130a being damaged by a plating solution.

The first metal layer 120a may be formed to a thickness of 100 nm, and the second metal layer 130a may be formed to a thickness of 9 μm. If the first metal layer 120a is too thin, a substitution reaction may occur between the first metal layer 120a and an adhesive layer during the formation of circuit patterns and the adhesive layer. Therefore, the first metal layer 120a is formed to more than a certain thickness. This directly applies to a double-sided flexible film.

The first metal layer 120a or the first metal layers 120b are seed layers formed on the dielectric film 110a or 110b. The first metal layer 120a or the first metal layers 120b may include nickel, chromium, gold or copper. More specifically, the first metal layer 120a or the first metal layers 120b may be formed of an alloy of nickel and chromium through sputtering. Alternatively, the first metal layer 120a or the first metal layers 120b may be formed of gold or copper through electroless plating.

More specifically, the first metal layer 120a or the first metal layers 120b may be formed through electroless plating by immersing the dielectric film 110a or 110b in an electroless plating solution containing metal ions and adding a reducing agent to the electroless plating solution so as to extract the metal ions as a metal. The thickness of the first metal layer 120a or the first metal layers 120b may be determined according to the amount of time for which the dielectric film 110a or 110b is immersed in the electroless plating solution.

The thickness of the first metal layer 120a or the first metal layers 120b may vary according to the type of method used to form the first metal layer 120a or the first metal layers 120b. For example, in the case of using sputtering, the first metal layer may be formed to a thickness of about 30 nm. On the other hand, in the case of using electroless plating, the first metal layer may be formed to a thickness of about 0.1 μm.

The second metal layer may be formed through electroplating by immersing the dielectric film 110a or 110b, on which the first metal layer 120a or the first metal layers 120b are formed, in an electroplating solution containing, for example, copper sulphate, and applying a current to the electroplating solution. The thickness of the second metal layer may be determined according to the intensity of a current and the duration of the application of a current. The second metal layer may be formed to a thickness of 4-13 μm.

Circuit patterns may be formed by etching the metal layer. In order to protect the circuit patterns, a protective film may be formed on the flexible film 100a or 100b. The protective film may include a dielectric film that can protect the circuit patterns. For example, the protective film may include polyethylene terephthalate (PET).

An adhesive layer may be used to attach the protective film on the flexible film 100a or 100b. The adhesive layer may include epoxy and may be formed to a thickness of 2-10 μm. If the adhesive layer has a thickness of less than 2 μm, the protective film may easily be detached from the flexible film 100a or 100b during the transportation or the storage of the flexible film 100a or 100b. If the adhesive layer has a thickness of more than 10 μm, the manufacturing cost of the flexible film 100a or 100b and the time taken to manufacture the flexible film 100a or 100b may increase, and it may be very difficult to remove the protective film.

FIGS. 1C and 1D illustrate cross-sectional views of flexible films 100c and 100d, respectively. Referring to FIG.

1C, the flexible film 100c has a triple-layer structure and is single-sided. Referring to FIG. 1D, the flexible film 100d also has a triple-layer structure and is double-sided.

The flexible film 100c includes a dielectric film 110c, a first metal layer 120c which is disposed on the dielectric film 100c, a second metal layer 130c which is disposed on the first metal layer 130c, and a third metal layer 140c which is disposed on the second metal layer 130c. The flexible film 100d includes a dielectric film 110d, two first metal layers 120d which are disposed on the top surface and the bottom surfaces, respectively, of the dielectric film 110d, two second metal layers 130d which are disposed on the respective first metal layers 120d, and two third metal layers 140d which are disposed on the respective second metal layers 130d. The first metal layer 120c, the first metal layers 120d, the second metal layer 130c, and the second metal layers 130d may be formed through sputtering, and the third metal layer 140c and the third metal layers 140d may be formed through electroplating.

More specifically, the first metal layer 120c or the first metal layers 120d may be formed through sputtering. The first metal layer 120c or the first metal layers 120d may be formed of an alloy of nickel and chromium, and particularly, an alloy of nickel and chromium in a content ratio of 97:3 or an alloy of nickel and chromium in a content ratio of 93:7. The first metal layer may be formed to a thickness of 7-20 nm.

If the first metal layer 120c or the first metal layers 120d are formed of an alloy of nickel and chromium, the efficiency of electroplating for forming the third metal layer 140c or the third metal layers 140d may decrease due to a high resistance of the alloy of nickel and chromium. Therefore, the second metal layer 130c or the second metal layers 130d may be formed of a metal having low resistance, thereby increasing the efficiency of electroplating for forming the third metal layer 140c or the third metal layers 140d.

If the first metal layer 120c or the first metal layers 120d are formed of an alloy of nickel and chromium, the second metal layer 130c or the second metal layers 130d may be formed of a highly-conductive metal on the first metal layer 120c or the first metal layers 120d by using sputtering in order to reduce the resistance of the first metal layer 120c or the first metal layers 120d. The second metal layer 130c or the second metal layers 130d may be formed of copper. The sum of the thicknesses of the first metal layer 120c and the second metal layer 130c may be about 100 nm. And this directly applies to a double-sided flexible film

The third metal layer 140c or the third metal layers 140d may include a highly-conductive metal such as gold or copper. The third metal layer 140c or the third metal layers 140d may be formed through electroplating. Once the third metal layer 140c or the third metal layers 140d are formed, circuit patterns for transmitting electric signals provided by a driving unit of a display device to electrodes on a panel of the display device are formed on the metal layer. More specifically, the circuit patterns may be formed by etching the first metal layer 120c, the second metal layer 130c and the third metal layer 140c or etching the first metal layers 120d, the second metal layers 130d and the third metal layers 140d.

FIGS. 1E and 1F illustrate cross-sectional views of a flexible film 100e and a flexible film 100f, respectively. Referring to FIG. 1E, the flexible film 100e has a single-layer structure and is single-sided. Referring to FIG. 1F, the flexible film 100f also has a single-layer structure and is double-sided.

The flexible film 100e includes a dielectric film 110e and a metal layer 120e which is disposed on the dielectric film 110e. The flexible film 110f includes a dielectric film 110f and two metal layers 120f which are disposed on the top surface and the bottom surface, respectively of the dielectric film 110f. The metal layer 120e and the metal layers 120f may be formed through casting or laminating. In order to effectively transmit electric signals, the metal layer 120e or the metal layers 120f may be formed of a highly-conductive metal such as copper.

The metal layer 120e and the metal layers 120f may be formed through laminating. More specifically, an adhesive may be applied onto the dielectric film 110e or 110f, and the dielectric film 110e or 110f may be baked in an oven so that the adhesive can be fixed onto the dielectric film 110e or 110f. Thereafter, the metal layer 120e or the metal layers 120f may be laid over the dielectric film 110e or 110f, and press processing may be performed on the metal layer 120e or the metal layers 120f, thereby forming the flexible film 100e or 100f.

Alternatively, the metal layer 120e and the metal layers 120f may be formed through casting. More specifically, a liquid-phase precursor of the dielectric film 110e or 110f may be applied, and may then be dried and hardened in an oven at high temperature, thereby forming the flexible film 100e or 100f.

Once the metal layer 120e and the metal layers 120f are formed either through casting or through laminating, circuit patterns for transmitting electric signals provided by a driving unit of a display device to electrodes on a panel of the display device are formed on the metal layer 120e or the metal layers 120f. More specifically, the circuit patterns may be formed by etching the metal layer 120e or the metal layers 120f.

FIGS. 2A and 2B illustrate diagrams of a tape carrier package (TCP) 200 including a flexible film 210 according to an embodiment of the present invention. Referring to FIG. 2A, the TCP 200 includes the flexible film 210, circuit patterns 220, which are formed on the flexible film 210, and an integrated circuit (IC) chip 230.

The flexible film 210 includes a dielectric film and a metal layer, which is formed on the dielectric film.

The metal layer may include a first metal layer, which is formed on the dielectric film, and a second metal layer, which is formed on the first metal layer. The first metal layer may be formed through electroless plating, and the second

metal layer may be formed through electroplating.

The first metal layer may include nickel, chromium, gold or copper. More specifically, the first metal layer may be formed of a highly-conductive metal such as nickel or copper in order to improve the efficiency of electroplating for forming the second metal layer.

Alternatively, the first metal layer may be formed through electroless plating by immersing the dielectric film in a copper sulphate-based electroless plating solution and extracting copper ions from the copper sulphate-based electroless plating solution as copper with the use of a reducing agent. A formaldehyde (HCHO)-series material may be used as the reducing agent.

The second metal layer may be formed by applying a current to a copper sulphate-based electroplating solution so as to extract copper ions as copper. The thickness of the second metal layer may be determined according to the amount of current applied. Once the second metal layer is formed, the circuit patterns 220 are formed by etching the first and second metal layers.

The circuit patterns 220 include inner leads 220a, which are connected to the IC chip 230, and outer leads 220b, which are connected to a driving unit or a panel of a display device. The pitch of the circuit patterns 220 may vary according to the resolution of a display device comprising the TCP 200. The inner leads 220a may have a pitch of about 30 $\mu$m, and the outer leads 220b may have a pitch of about 60 $\mu$m.

FIG. 2B illustrates a cross-sectional view taken along line 2-2' of FIG. 2A. Referring to FIG. 2B, the TCP 200 includes the flexible film 210, the IC chip 230, and gold bumps 240, which connect the flexible film 210 and the IC chip 230.

The flexible film 210 may include a dielectric film 212 and a metal layer 214, which is formed on the dielectric film 212. The dielectric film 212 is a base film of the flexible film 210 and may include a dielectric polymer material such as polyimide, polyester, or a liquid crystal polymer. In order to enhance the flexibility and the thermal resistance of the flexible film 210 and the stability of dimension of the circuit patterns 220 and provide sufficient peel strength with respect to the metal layer 214, the dielectric film 212 may be formed to a thickness of 15-40 $\mu$m, and particularly, 35-38 $\mu$m.

The metal layer 214 is a thin layer formed of a conductive metal such as nickel, chromium, gold or copper. The metal layer 214 may have a double-layer structure including first and second metal layers. The first metal layer may be formed of nickel, gold, chromium or copper through electroless plating, and the second metal layer may be formed of gold or copper through electroplating. In order to improve the efficiency of electroplating for forming the second metal layer, the first metal layer may be formed of nickel or copper.

The metal layer 214 may be formed to such a thickness that the ratio of the thickness of the metal layer 214 to the thickness of the dielectric film 212 can be 1:1.5-5:10. If the thickness of the metal layer 214 is less than one tenth of the thickness of the dielectric film 212, the stability of dimension of the circuit patterns 220 and the peel strength of the metal layer 214 may deteriorate. On the other hand, if the thickness of the metal layer 214 is larger than two thirds of the thickness of the dielectric film 212, the time taken to perform plating for forming the metal layer 212 may increase, thereby increasing the probability of the flexible film 210 being damaged by a plating solution.

The IC chip 230 is disposed on the flexible film 210 and is connected to the circuit patterns 220, which are formed by etching the metal layer 214. The flexible film 210 includes a device hole 250, which is formed in an area in which the IC chip 230 is disposed. After the formation of the device hole 250, flying leads are formed on the circuit patterns 220, to which the IC chip 230 is connected, and the gold bumps 240 on the IC chip 230 are connected to the flying leads, thereby completing the formation of the TCP 200. The flying leads may be plated with tin. The flying leads may be plated with tin. A gold-tin bond may be generated between the tin-plated flying leads and the gold bumps 240 by applying heat or ultrasonic waves.

FIGS. 3A and 3B illustrate diagrams of a chip-on-film (COF) 300 including a flexible film 310 according to an embodiment of the present invention. Referring to FIG. 3A, the COF 300 includes the flexible film 310, circuit patterns 320, which are formed on the flexible film 310, and an IC chip 330, which is attached on the flexible film 310 and is connected to the circuit patterns 320.

The flexible film 310 may include a dielectric film and a metal layer, which is disposed on the dielectric film. The dielectric film, which is a base film of the flexible film 310, may be formed of a dielectric polymer material such as polyimide, polyester or a liquid crystal polymer. The dielectric film may considerably affect the physical properties of the flexible film 310 and may thus include a dielectric polymer material having high thermal resistance, a high thermal expansion coefficient, high dimension stability and low water absorbency.

The water absorbency of the dielectric film may be 0.01-3.5% under IPC TM-650 2.6.2 conditions.

Table 2

| Water Absorbency (%) | Signal Transmission Efficiency | Errors |
|---|---|---|
| Less than 0.01 | ◎ | ○ |
| 0.01 | ○ | × |

(continued)

| Water Absorbency (%) | Signal Transmission Efficiency | Errors |
|---|---|---|
| 0.1 | ○ | × |
| 1 | ○ | × |
| 2 | ○ | × |
| 2.5 | ○ | × |
| 3 | ○ | × |
| 3.5 | ○ | × |
| 3.6 | × | × |
| 3.7 | × | × |

Referring to Table 2, if the dielectric film has a water absorbency of more than 3.5%, the permittivity of the flexible film 310 may increase due to the absorption of moisture by the dielectric film, and thus, the impedance of the flexible film 310 such as parasitic capacitance may also increase. Therefore, it may be impossible for the COF 300 to efficiently transmit signals having a high scan rate. On the other hand, if the dielectric film has a water absorbency of less than 0.01%, moisture near the COF 300 may infiltrate into the circuit patterns 320 or the IC chip 330, thereby adversely affecting the operation of the COF 300.

The metal layer may be formed on the dielectric film through sputtering, electroless plating or electroplating. The circuit patterns 320 may be formed by etching the metal layer. The circuit patterns 320 include inner leads 320a, which are connected to the IC chip 330, and outer leads 320b, which are connected to a driving unit or a panel of a display device. The outer leads 320b may be connected to a driving unit or a panel of a display device by anisotropic conductive films (ACFs).

More specifically, the outer leads 320b may be connected to a driving unit or a panel of a display device through outer lead bonding (OLB) pads, and the inner leads 320a may be connected to the IC chip 330 through inner lead bonding (ILB) pads. The IC chip 330 and the inner leads 320a may be connected by plating the inner leads 320a with tin and applying heat or ultrasonic waves to the tin-plated inner leads 320a so as to generate a gold-tin bond between the tin-plated inner leads 320a and gold bumps on the IC chip 330.

The metal layer may have a double-layer structure including first and second metal layers. The first metal layer may be formed through sputtering or electroless plating and may include nickel chromium, gold or copper. The second metal layer may be formed through electroplating and may include gold or copper. In order to improve the efficiency of electroplating for forming the second metal layer, the first metal layer may be formed of a metal having a low resistance such as copper or nickel.

FIG. 3B illustrates a cross-sectional view taken along line 3-3' of FIG. 3A. Referring to FIG. 3B, the COF 300 includes the flexible film 310, which includes a dielectric film 312 and a metal layer 314 formed on the dielectric film 312, the IC chip 330, which is connected to the circuit patterns 320 on the metal layer 314, and gold bumps 340, which connect the IC chip 330 and the circuit patterns 320.

The dielectric film 312 is a base film of the flexible film 310 and may include a dielectric polymer material such as polyimide, polyester, or a liquid crystal polymer. In order to provide HD broadcasting, it is necessary to transmit image signals having a high scan rate of about 120 Hz. For this, the dielectric film 312 may be formed of a material having low water absorbency. For example, the dielectric film 312 may be formed of a polymer having a water absorbency of 0.01-0.3% under IPC TM-650 2.6.2 conditions so as to improve the efficiency of the transmission of signals by the flexible film 310.

The metal layer 314 is a thin layer formed of a conductive metal. The metal layer 314 may include a first metal layer, which is formed on the dielectric film 312, and a second metal layer, which is formed on the first metal layer. The first metal layer may be formed through sputtering or electroless plating and may include nickel, chromium, gold or copper. The second metal layer may be formed through electroplating and may include gold or copper.

The first metal layer may be formed of an alloy of nickel and chromium though sputtering. Alternatively, the first metal layer may be formed of copper through electroless plating. When using an alloy of nickel and chromium, the first metal layer may be formed to a thickness of about 30 nm. When using copper, the first metal layer may be formed to a thickness of 0.1 $\mu$m.

The first metal layer may be formed through electroless plating by immersing the dielectric film 312 in an electroless plating solution containing metal ions and adding a reducing agent to the electroless plating solution so as to extract the metal ions as a metal. The thickness of the first metal layer may be altered by adjusting the amount of

time for which the dielectric film 312 is immersed in an electroless plating solution.

The second metal layer may be formed through electroplating, which involves applying a current to an electroplating solution and extracting metal ions contained in the electroplating solution as a metal. The thickness of the second metal layer may be determined according to the intensity of a current applied and the duration of the application of a current. The second metal layer may be formed to a thickness of 4-13 μm.

The IC chip 330 is connected to the inner leads 320a of the circuit patterns 320 and transmits image signals provided by a driving unit of a display device to a panel of the display device. The pitch of the inner leads 320a may vary according to the resolution of a display device to which the COF 300 is connected. The inner leads 320a may have a pitch of about 30 μm. The IC chip 330 may be connected to the inner leads 320a through the gold bumps 340.

Referring to FIG. 3B, the COF 300, unlike the TCP 200, does not have any device hole 250. Therefore, the COF 300 does not require the use of flying leads and can thus achieve a fine pitch. In addition, the COF 300 is very flexible, and thus, there is no need to additionally form slits in the COF 300 in order to make the COF 300 flexible. Therefore, the efficiency of the manufacture of the COF 300 can be improved. For example, leads having a pitch of about 40 μm may be formed on the TCP 200, and leads having a pitch of about 30 μm can be formed on the COF 300. Thus, the COF 300 is suitable for use in a display device having a high resolution.

A display device according to an embodiment of the present invention may include a panel, which displays an image, a driving unit, which applies an image signal to the panel, a flexible film, which connects the panel and the driving unit, and conductive films, which are used to attach the flexible film to the panel and to the driving unit. The display device may be a flat panel display (FPD) such as a liquid crystal display (LCD), a plasma display panel (PDP) or an organic light-emitting device (OLED).

The panel includes a plurality of pixels for displaying an image. A plurality of electrodes may be arranged on the panel and may be connected to the driving unit. The pixels are disposed at the intersections among the electrodes. More specifically, the electrodes include a plurality of first electrodes and a plurality of second electrodes, which intersect the first electrodes. The first electrodes may be formed in row direction, and the second electrodes may be formed in a column direction.

The flexible film is a film comprising circuit patterns printed thereon. The flexible film includes a dielectric film, a metal layer, which is formed on the dielectric film, and an IC chip, which is connected to circuit patterns formed on the metal layer. An image signal applied by the driving unit may be transmitted to the electrodes on the panel through the circuit patterns and the IC chip of the flexible film. The flexible film may be connected to the panel, the driving unit and the conductive films.

The conductive film may be an adhesive film. The conductive films may be disposed between the flexible film and the panel and between the driving unit and the flexible film. The conductive films may be ACFs.

While the present invention has been particularly shown and described with reference to exemplary embodiments thereof, it will be understood by those of ordinary skill in the art that various changes in form and details may be made therein without departing from the present invention as defined by the following claims.

## Claims

1. A flexible film (100a-f, 210, 310) comprising:

   a dielectric film (110a-f, 212, 312);
   a metal layer (214, 314) disposed on the dielectric film (110a-f, 212, 312), the metal layer (214, 314) comprising:

      a first metal layer (120a-f) electroless-plated on the dielectric film (110a-f, 212, 312); and
      a second metal layer (130a-f) electro-plated on the first metal layer (120a-f).;

   wherein a water absorbency of the dielectric film (110a-f, 212-, 312) is about 0.01-3.5 %,
   **characterized in that** the ratio of the thickness of the metal layer (214, 314) to the thickness of the dielectric film (110a-f, 212, 312) is about 1:1.5 to 1:10.

2. The flexible film of claim 1, wherein the dielectric film (110a-f, 212, 312) comprises at least one of polyimide, polyester, and a liquid crystal polymer.

3. The flexible film of claim 1, wherein the metal layer (214, 314) comprises one of nickel, chromium, gold, and copper.

4. The flexible film of one of claims 1-3, wherein the metal layer (214, 314) further comprises circuit patterns (220, 330) printed thereon.

5. The flexible film of one of claims 1-4 wherein the metal layer (214, 314) comprises an integrated circuit chip (230, 330) disposed thereon.

6. The flexible film of claim 5, further comprising a device hole (250) formed in an area in which the integrated circuit chip (230, 330) is disposed.

7. The flexible film of claim 6, further comprising gold bumps formed on the metal layer, wherein the integrated circuit chip (230, 330) is connected to the circuit patterns (220, 320) through the gold bumps (240).

8. A display device comprising:

a panel;
a driving unit; and
the flexible film (100a-f, 210, 310) of any one of claims 1-5,7 disposed between the panel and the driving unit.

9. The display device of claim 8, further comprising outer leads (320b) of the circuit pattern, and an anisotropic conductive film connecting the panel or the driving unit to the outer Leads (320b) of the circuit pattern printed on the flexible film (100a-f, 210, 310).

**Patentansprüche**

1. Flexibler Film (100a-f, 210, 310), umfassend:

einen dielektrischen Film (110a-f, 212, 312);
eine Metallschicht (214, 314), die auf dem dielektrischen Film (110a-f, 212, 312) angeordnet ist, wobei die Metallschicht (214, 314) umfasst:

eine erste Metallschicht (120a-f), die reduktiv chemisch auf dem dielektischen Film (110a-f, 212, 312) aufgebracht ist; und
eine zweite Metallschicht (130a-f), die reduktiv chemisch auf der ersten Metallschicht (120a-f) aufgebracht ist;

wobei ein Wasserabsorptionsvermögen des dielektischen Films (110a-f, 212, 312) etwa 0,01-3,5 % beträgt, **dadurch gekennzeichnet, dass** das Verhältnis der Dicke der Metallschicht (214, 314) zur Dicke des dielektischen Films (110a-f, 212, 312) etwa 1:1,5 bis 1:10 ist.

2. Flexibler Film nach Anspruch 1, wobei der dielektische Film (110a-f, 212, 312) wenigstens eines von Polyimid, Polyester und einem Flüssigkristallpolymer umfasst.

3. Flexibler Film nach Anspruch 1, wobei die Metallschicht (214, 314) ein Element aus Nickel, Chrom, Gold und Kupfer umfasst.

4. Flexibler Film nach einem der Ansprüche 1-3, wobei die Metallschicht (214, 314) ferner darauf gedruckte Schaltkreismuster (220, 330) umfasst.

5. Flexibler Film nach einem der Ansprüche 1-4, wobei die Metallschicht (214, 314) einen darauf angeordneten integrierten Schaltkreis-Chip (230, 330) umfasst.

6. Flexibler Film nach Anspruch 5, ferner umfassend ein Bauteilloch (250), das in einem Bereich ausgebildet ist, in welchem der integrierte Schaltkreis-Chip (230, 330) angeordnet ist.

7. Flexibler Film nach Anspruch 6, ferner umfassend auf der Metallschicht gebildete Gold-Bumps, wobei der integrierte Schaltkreis-Chip (230, 330) über die Gold-Bumps (240) mit den Schaltkreismustern (220, 320) verbunden ist.

8. Anzeigevorrichtung, umfassend:

ein Paneel;

eine Steuerungseinheit; und
den flexiblen Film (100a-f, 210, 310) nach einem der Ansprüche 1-5 und 7, der zwischen dem Paneel und der Steuerungseinheit angeordnet ist.

**9.** Anzeigevorrichtung nach Anspruch 8, ferner umfassend äußere Leitungen (320b) des Schaltkreismusters und einen anisotropen leitfähigen Film, welcher das Paneel oder die Steuerungseinheit mit den äußeren Leitungen (320b) des auf den flexiblen Film (100a-f, 210, 310) gedruckten Schaltkreismusters verbindet.

## Revendications

**1.** Film flexible (100a-f, 210, 310) comprenant :

un film diélectrique (110a-f, 212, 312) ;
une couche de métal (214, 314) disposée sur le film diélectrique (110a-f, 212, 312), la couche de métal (214, 314) comprenant :

une première couche de métal (120a-f) plaquée par dépôt autocatalytique sur le film diélectrique (110a-f, 212, 312) ; et
une deuxième couche de métal (130a-f) plaquée par dépôt électrolytique sur la première couche de métal (120a-f) ;

dans lequel une absorption d'eau du film diélectrique (110a-f, 212, 312) est environ 0,01 à 3,5%,
**caractérisé en ce que** le rapport de l'épaisseur de la couche de métal (214, 314) sur l'épaisseur du film diélectrique (110a-f, 212, 312) est environ 1:1,5 à 1:10.

**2.** Film flexible selon la revendication 1, dans lequel le film diélectrique (110a-f, 212, 312) comprend au moins l'un d'un polyimide, d'un polyester et d'un polymère à cristaux liquides.

**3.** Film flexible selon la revendication 1, dans lequel la couche de métal (214, 314) comprend l'un du nickel, du chrome, de l'or et du cuivre.

**4.** Film flexible selon l'une des revendications 1 à 3, dans lequel la couche de métal (214, 314) comprend en outre des tracés de circuit (220, 330) imprimés sur celle-ci.

**5.** Film flexible selon l'une des revendications 1 à 4, dans lequel la couche de métal (214, 314) comprend une puce de circuit intégré (230, 330) disposée sur celle-ci.

**6.** Film flexible selon la revendication 5, comprenant en outre un trou (250) pour un dispositif formé dans une zone dans laquelle la puce de circuit intégré (230, 330) est disposée.

**7.** Film flexible selon la revendication 6, comprenant en outre des bossages d'or formés sur la couche de métal, dans lequel la puce de circuit intégré (230, 330) est connectée aux tracés de circuit (220, 330) par l'intermédiaire des bossages d'or (240).

**8.** Dispositif d'affichage comprenant :

un panneau ;
une unité d'entraînement ; et
le film flexible (100a-f, 210, 310) selon l'une quelconque des revendications 1 à 5, 7 disposé entre le panneau et l'unité d'entraînement.

**9.** Dispositif d'affichage selon la revendication 8, comprenant en outre des fils conducteurs extérieurs (320b) du tracé de circuit, et un film conducteur anisotrope connectant le panneau ou l'unité d'entraînement aux fils conducteurs extérieurs (320b) du tracé de circuit imprimé sur le film flexible (100a-f, 210, 310).

Fig.1a

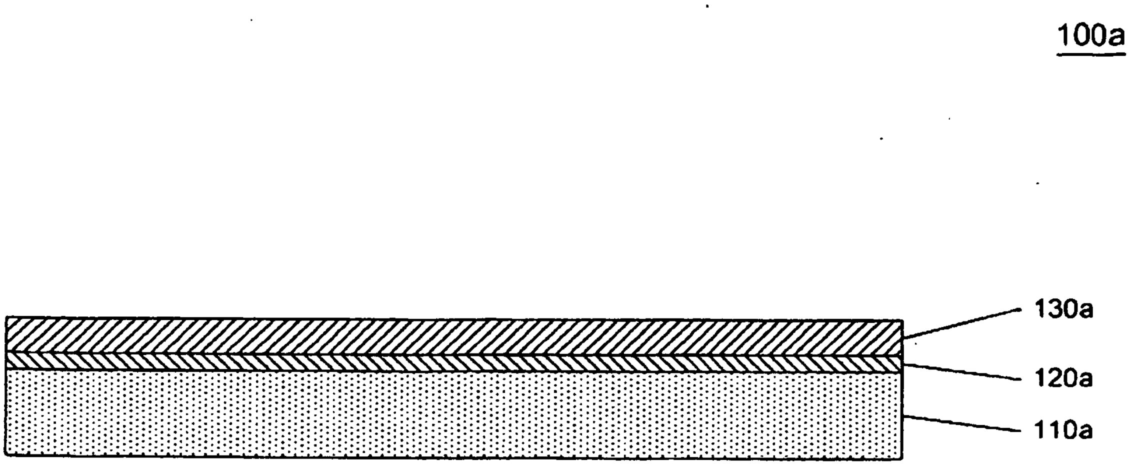


Fig.1b

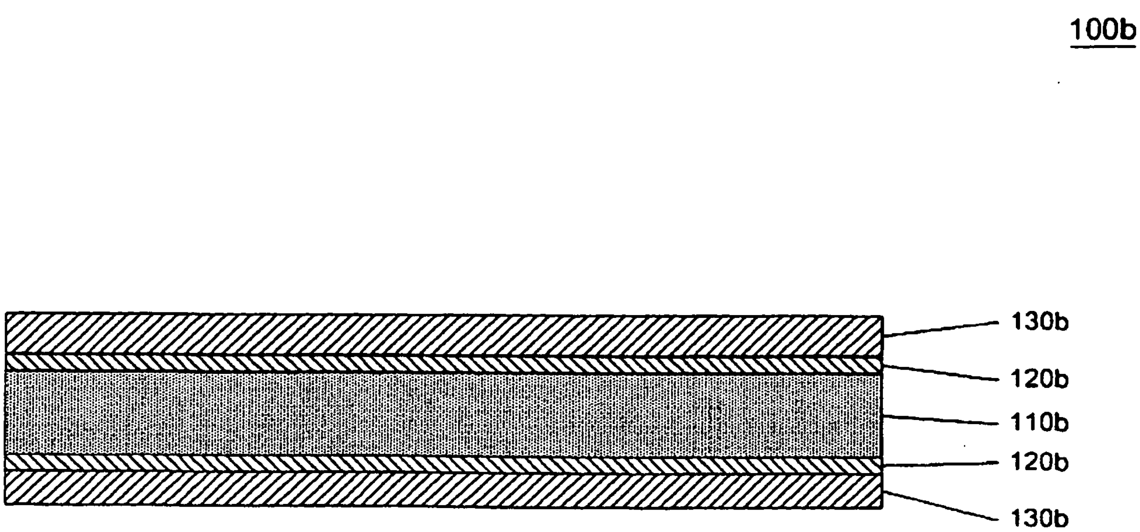

Fig.1c

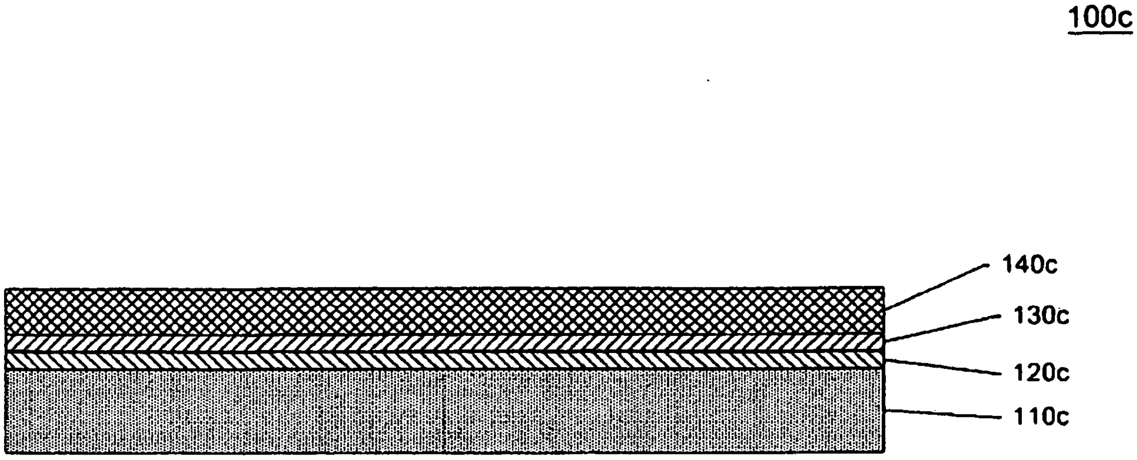
100c
140c
130c
120c
110c

Fig.1d

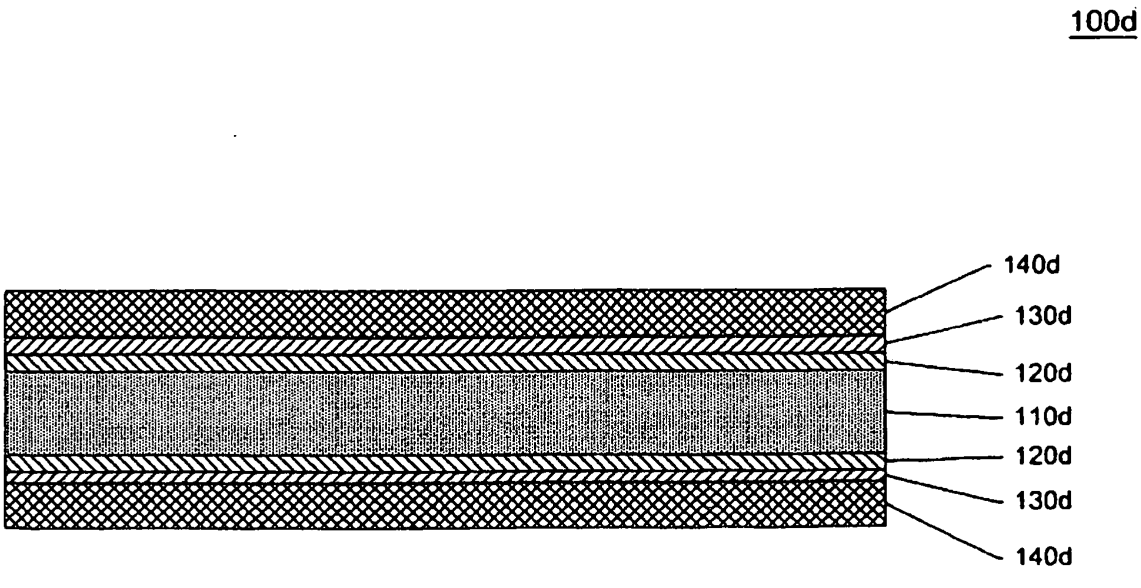
100d
140d
130d
120d
110d
120d
130d
140d

Fig.1e

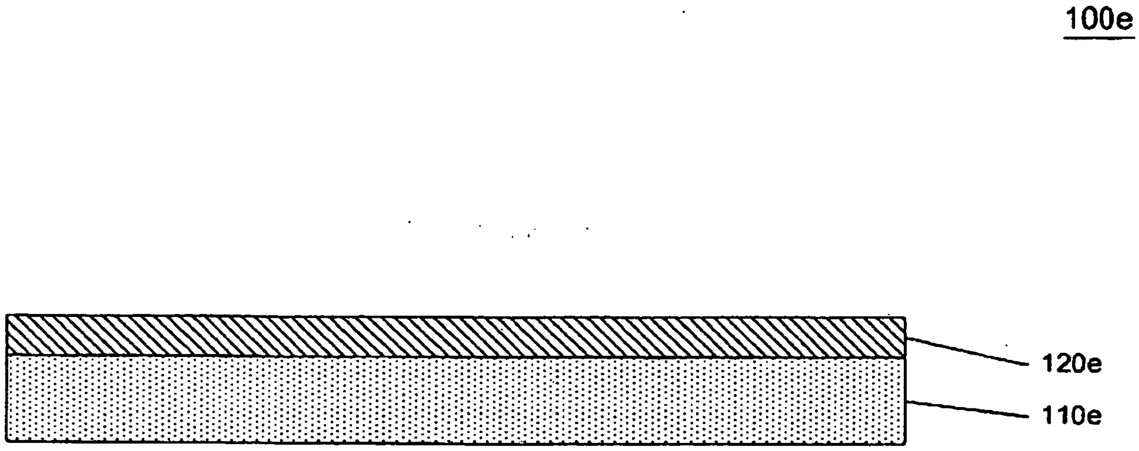


Fig.1f

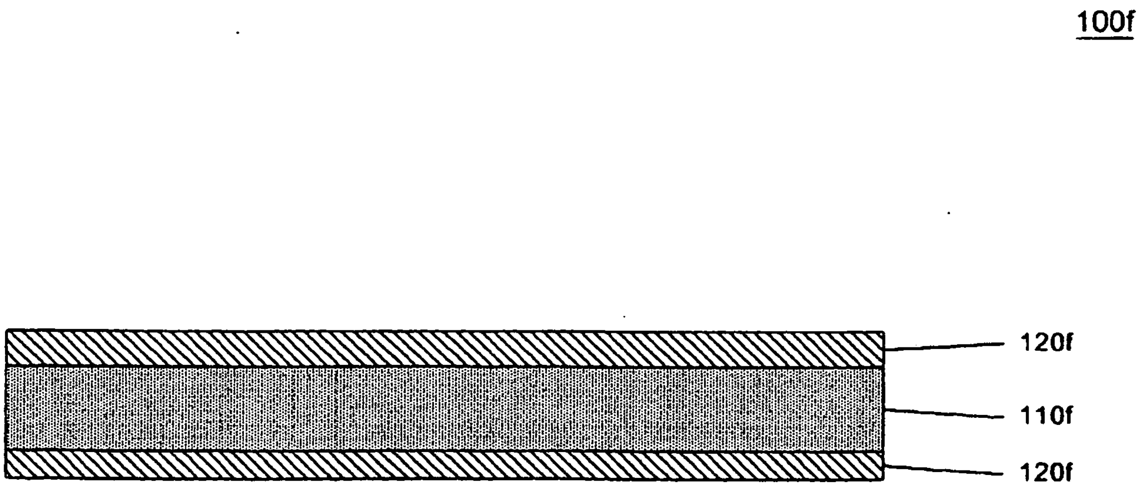

Fig.2a

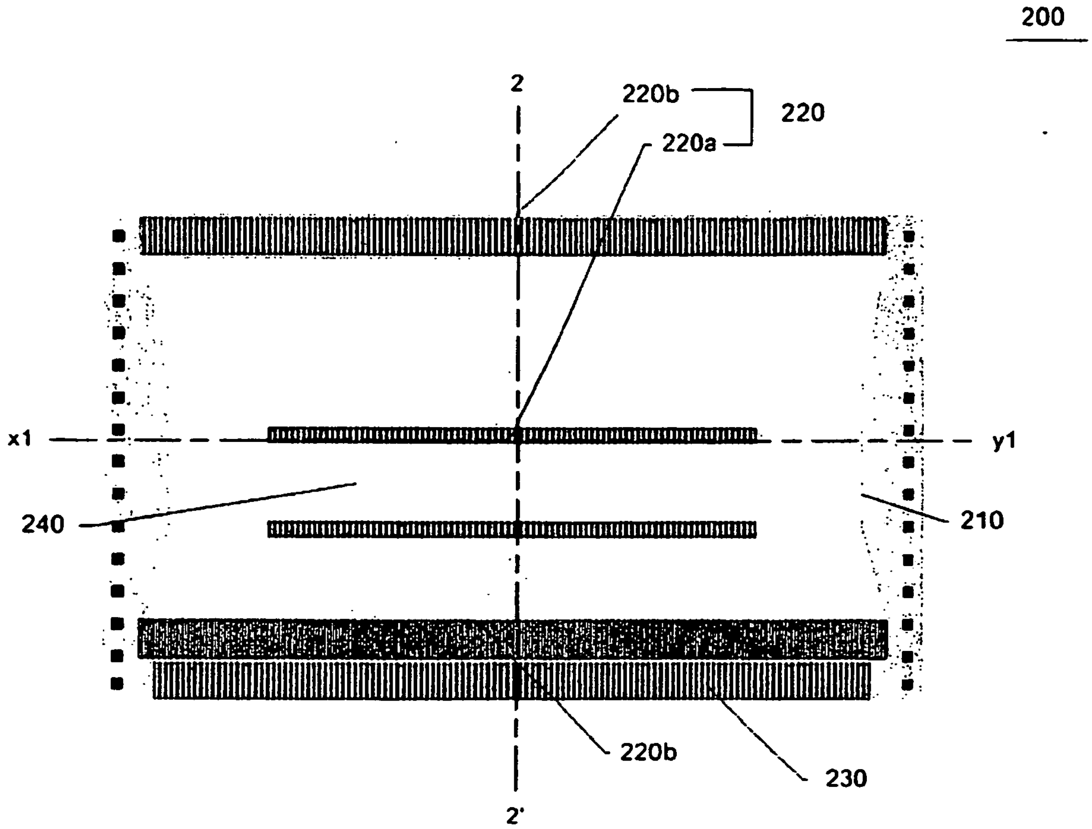
200
2
220b
220
220a
x1
y1
240
210
220b
230
2'

Fig.2b

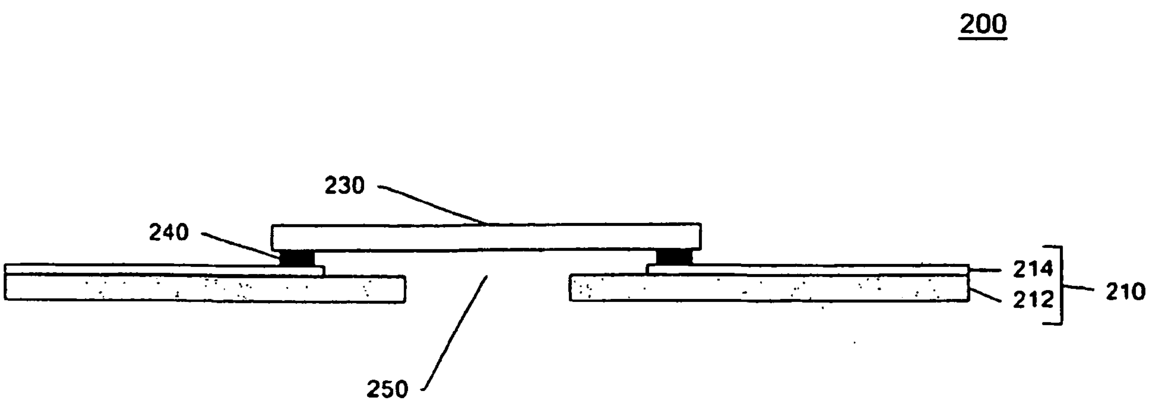
200
230
240
214
212
210
250

Fig.3a

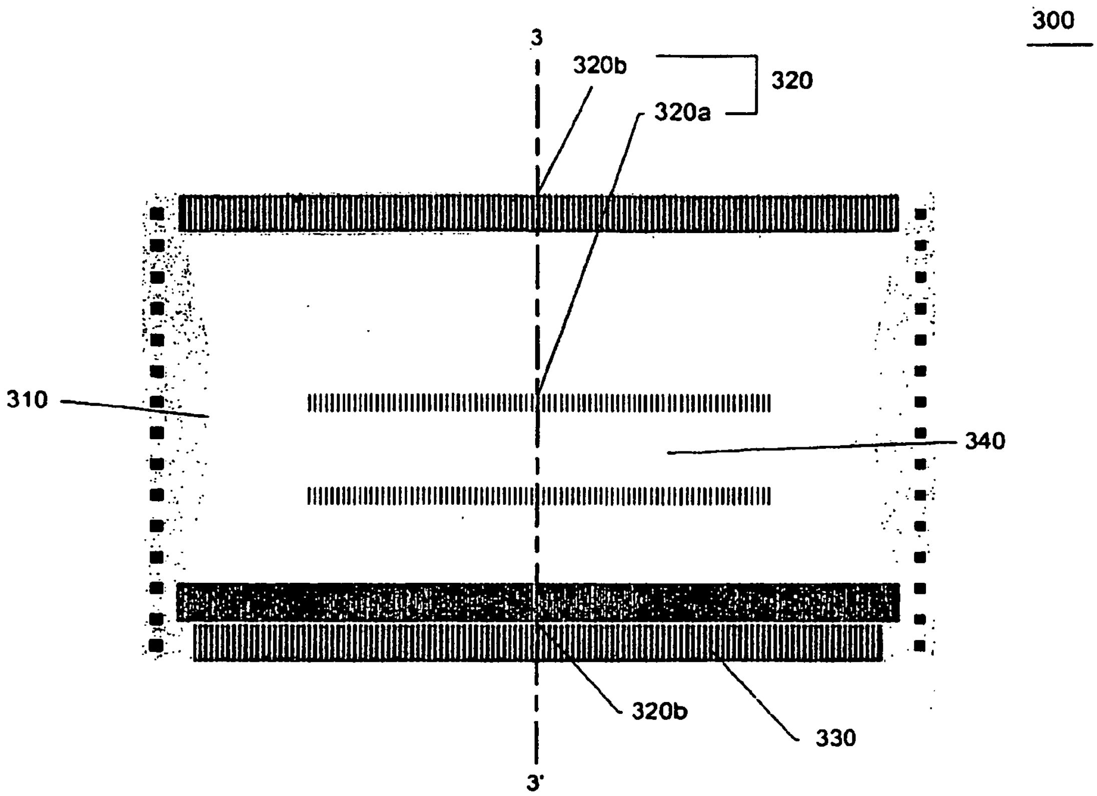


Fig.3b

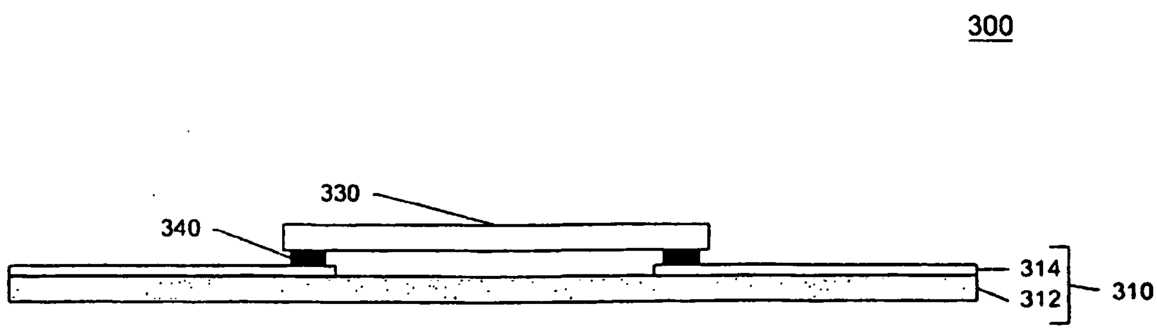

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1529812 A
- US 20040140551 A
- US 20030024666 A